# EUROPEAN PATENT APPLICATION

(11) **EP 4 679 977 A1**
(43) Date of publication of application: **14.01.2026**
(21) Application number: 25177244.8
(22) Date of filing: 19.05.2025
(51) Int. Cl.: H10F 19/75, H10F 77/20, H10F 71/00

(54) **SOLAR CELL AND METHOD FOR PREPARING SAME**

(30) Priority: 10.07.2024 CN 202410917742; 10.07.2024 CN 202421618721 U
(71) Applicant: CSI Cells (YangZhou) Co., Ltd., Yangzhou, Jiangsu 225000 (CN)
(72) Inventor: CHEN, Haiyan, Suzhou, 215000 (CN); DENG, Weiwei, Suzhou, 215000 (CN)
(74) Representative: Luo, Runhan

(57) **Abstract**

Provided are a solar cell and a method for preparing the solar cell. The solar cell includes a silicon substrate having a front surface and a back surface. The silicon substrate includes a P-type region located on the back surface, an N-type region located on the back surface; and an isolation region located between the P-type region and the N-type region. The solar cell further includes a first electrode disposed in the P-type region, a second electrode disposed in the N-type region, and an electrical connector disposed in the isolation region and configured to electrically connect a part of the P-type region and a part of the N-type region. In the solar cell and the method for preparing the same of the present disclosure, the electrical connector is provided to connect the parts of the P-type region and the N-type region, and therefore serves as a bypass path when the cell is partially obscured by shadow, reducing a power loss of the cell.

## Description

### FIELD

The present disclosure relates to the field of photovoltaics, and in particular, to a solar cell and a method for preparing the solar cell.

### BACKGROUND

Photovoltaic modules are typically mounted in areas with abundant sunlight, such as rooftops, hillsides, deserts, and Gobi terrains. However, an outdoor environment is complex, and thus the modules are often obscured by dust, leaves, and other debris during use. When partial shadow obscuration occurs, a loss of the modules can be significant.

**In** view of this, it is necessary to provide an improved solar cell and a method for preparing the same to solve the above technical problems.

### SUMMARY

The present disclosure provides a solar cell and a method for preparing the solar cell, to solve problems such as a loss of a cell efficiency caused by shadow obscuration.

**In** a first aspect, the present disclosure provides a solar cell. The solar cell includes a silicon substrate having a front surface and a back surface. The silicon substrate includes a P-type region located on the back surface, an N-type region located on the back surface; and an isolation region located between the P-type region and the N-type region. The solar cell further includes a first electrode disposed in the P-type region, a second electrode disposed in the N-type region, and an electrical connector disposed in the isolation region and configured to electrically connect a part of the P-type region and a part of the N-type region.

In an optional embodiment, the front surface of the silicon substrate refers to the main light-receiving surface of the silicon substrate, while the back surface of the silicon substrate refers to the secondary light-receiving surface of the silicon substrate.

In an optional embodiment, a resistance of the electrical connector is smaller than a resistance of the isolation region; and the resistance of the electrical connector is equal to or greater than a resistance of the P-type region, or the resistance of the electrical connector is equal to or greater than a resistance of the N-type region.

In an optional embodiment, the electrical connector is made of the same material as the N-type region, and the electrical connector extends from the N-type region towards the isolation region.

In an optional embodiment, the electrical connector is made of the same material as the P-type region, and the electrical connector extends from the P-type region towards the isolation region.

In an optional embodiment, the silicon substrate includes a plurality of P-type regions and a plurality of N-type regions. The plurality of P-type regions and the plurality of N-type regions are alternately arranged in a first direction.

In an optional embodiment, each of the plurality of N-type regions is electrically connected to a corresponding one of the plurality of P-type regions through the electrical connector at only one side of the N-type region in the first direction.

In an optional embodiment, each of the plurality of P-type regions is electrically connected to a corresponding one of the plurality of N-type regions through the electrical connector at only one side of the P-type region in the first direction.

In an optional embodiment, each of the plurality of P-type regions includes a first main grid region extending in a second direction and a plurality of first auxiliary grid regions extending in the first direction, the plurality of first auxiliary grid regions being arranged in the second direction, and the plurality of first auxiliary grid regions being connected to the first main grid region.

In an optional embodiment, each of the plurality of N-type regions includes a second main grid region extending in the second direction and a plurality of second auxiliary grid regions extending in the first direction, the plurality of second auxiliary grid regions being arranged in the second direction, the plurality of second auxiliary grid regions being connected to the second main grid region.

In an optional embodiment, the first main grid regions of the plurality of P-type regions and the second main grid regions of the plurality of N-type regions are alternately arranged in the first direction, and the plurality of first auxiliary grid regions of each of the plurality of P-type regions and the plurality of second auxiliary grid regions of a corresponding one of the plurality of N-type regions are alternately arranged in the second direction.

In an optional embodiment, the electrical connector is located in the isolation region around the first auxiliary grid region.

In an optional embodiment, the electrical connector is located in the isolation region around the second auxiliary grid region.

In an optional embodiment, for adjacent P-type region and N-type region, each of the plurality of second auxiliary grid regions is connected to the first main grid region through the electrical connectors.

In an optional embodiment, for adjacent P-type region and N-type region, each of the plurality of first auxiliary grid regions is connected to the second main grid region at different part through the electrical connector.

In an optional embodiment, for adjacent P-type region and N-type region, each of the plurality of first auxiliary grid regions is connected to one of the plurality of second auxiliary grid regions adjacent to the first auxiliary grid region through the electrical connector.

In an optional embodiment, the first direction is perpendicular to the second direction.

In an optional embodiment, for the isolation region between adjacent P-type region and N-type region, a ratio of an area of the electrical connectors to an area of the isolation region ranges from 0.1% to 2%.

In a second aspect, the present disclosure provides a method for preparing the above-mentioned solar cell. The method includes: forming a patterned P-type region on a back surface of a silicon substrate; forming a patterned N-type region on the back surface of the silicon substrate, wherein an isolation region is formed between the N-type region and the P-type region; forming an electrical connector in the isolation region on the back surface of the silicon substrate to electrically connect a part of the P-type region and a part of the N-type region; and forming a first electrode and a second electrode at the P-type region and the N-type region, respectively.

In an optional embodiment, the method for preparing the solar cell includes, in sequence: forming a boron diffusion layer on the entire back surface of the silicon substrate, and performing a laser etching to only keep the boron diffusion layer at a position of the P-type region; and forming a tunneling layer and an N-type polysilicon layer on the entire back surface, and performing a laser etching to only keep the tunneling layer and the N-type polysilicon layer that are located at positions of the N-type region and the electrical connector.

In an optional embodiment, the method for preparing the solar cell includes, in sequence: forming a boron diffusion layer on the entire back surface of the silicon substrate, and performing a laser etching to only keep the boron diffusion layer at positions of the P-type region and the electrical connector; and forming a tunneling layer and an N-type polysilicon layer on the entire back surface, and performing a laser etching to only keep the tunneling layer and the N-type polysilicon layer that are located at a position of the N-type region.

In an optional embodiment, the P-type region is a boron diffusion region having a doping concentration ranging from 5E18 cm⁻³ to 5E19 cm⁻³ or a sheet resistance ranging from 250 ohm/sq to 350 ohm/sq and having a junction depth ranging from 0.5 µm to 0.1 µm.

In an optional embodiment, the N-type region is phosphorus doped, carbon doped, or nitrogen doped, the N-type region having a doping concentration ranging from 3E20cm⁻³ to 5E20cm⁻³.

In an optional embodiment, said forming the tunneling layer and the N-type polysilicon layer on the entire back surface includes: growing the tunneling layer and an N-type amorphous silicon layer through PECVD by in-situ doping; and converting, by annealing at 850 °C to 980 °C, the N-type amorphous silicon layer into the N-type polysilicon layer.

In an optional embodiment, the method for preparing the solar cell further includes, subsequent to said forming the electrical connector, and prior to said forming the first electrode and the second electrode at the P-type region and the N-type region, respectively: forming a passivation layer on the entire back surface and an entire front surface of the silicon substrate; and forming an anti-reflection layer on the entire back surface and the entire front surface of the silicon substrate. The first electrode is in contact with the P-type region by penetrating the anti-reflection layer and the passivation layer that are located on the back surface of the silicon substrate. The second electrode is in contact with the N-type polysilicon layer by penetrating the anti-reflection layer and the passivation layer that are located on the back surface of the silicon substrate.

The present disclosure can provide the following advantageous effects. In the solar cell and the method for preparing the same of the present disclosure, the electrical connector is provided to connect the part of the P-type region and the part of the N-type region, and therefore serves as a bypass path when the cell is partially obscured by shadow, reducing a power loss of the cell.

### BRIEF DESCRIPTION OF THE DRAWINGS

FIG. 1 is a schematic structural view of a solar cell according to an embodiment of the present disclosure.
FIG. 2 is a schematic structural view of a back surface of a solar cell according to an embodiment of the present disclosure.
FIG. 3 is an enlarged partial view of a unit in FIG. 1.
FIG. 4 is a schematic view of a unit according to another embodiment.
FIG. 5 is a schematic view of a unit according to yet another embodiment.
FIG. 6 is a schematic structural view of a solar cell according to an embodiment of the present disclosure.
FIG. 7 is a flowchart of a method for preparing a solar cell according to an embodiment of the present disclosure.
FIG. 8 is a schematic view obtained of a patterned P-type region formed on a back surface of a silicon substrate based on the method illustrated in FIG. 7.
FIG. 9 is a schematic view after depositing a tunneling layer and an N-type amorphous silicon layer based on FIG. 8.
FIG. 10 is a schematic view after forming an N-type region and an electrical connector by a laser etching based on FIG. 9.
FIG. 11 is a flowchart of a method for preparing a solar cell according to another embodiment of the present disclosure.
FIG. 12 is a schematic view of a patterned P-type region and an electrical connector formed on a back surface of a silicon substrate based on the method illustrated in FIG. 11.

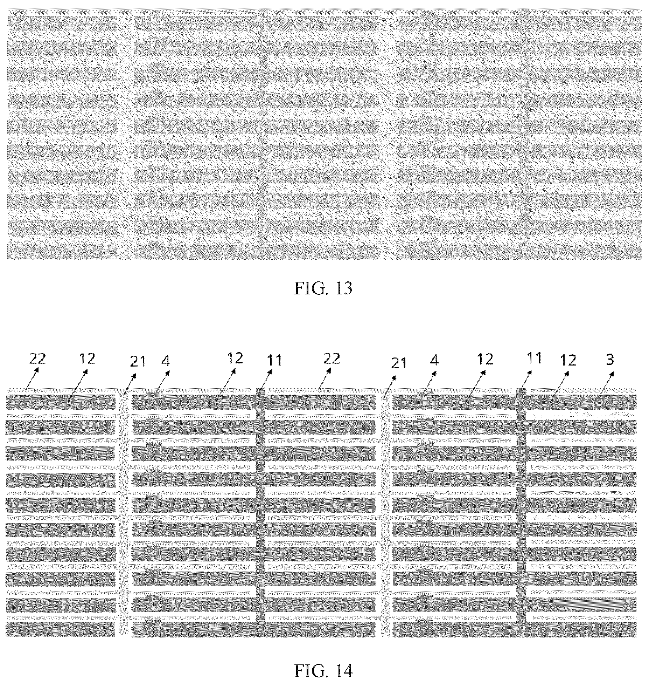

FIG. 13 is a schematic view after depositing a tunneling layer and an N-type amorphous silicon layer based on FIG. 12.
FIG. 14 is a schematic view after forming an N-type region by a laser etching based on FIG. 13.

100: solar cell; 101: silicon substrate; 102: front surface passivation layer; 103: front surface anti-reflection layer; 104: back surface passivation layer; 105: back surface anti-reflection layer; 1: P-type region; 11: first main grid region; 12: first auxiliary grid region; 2: N-type region; 21: second main grid region; 22: second auxiliary grid region; 3: isolation region; 4: electrical connector; 5: first electrode; 6: second electrode.

### DETAILED DESCRIPTION

The present disclosure will be described in detail below in combination with specific embodiments shown in the accompanying drawings, but these embodiments do not limit the present disclosure. Structural, methodological, or functional transformations made by those skilled in the art according to these embodiments shall fall within the scope of protection of the present disclosure.

In the accompanying drawings of the present disclosure, some dimensions of structures or parts are exaggerated relative to those of other structures or parts for ease of illustration, which is only intended to illustrate the basic structure of the subject matter of the present disclosure.

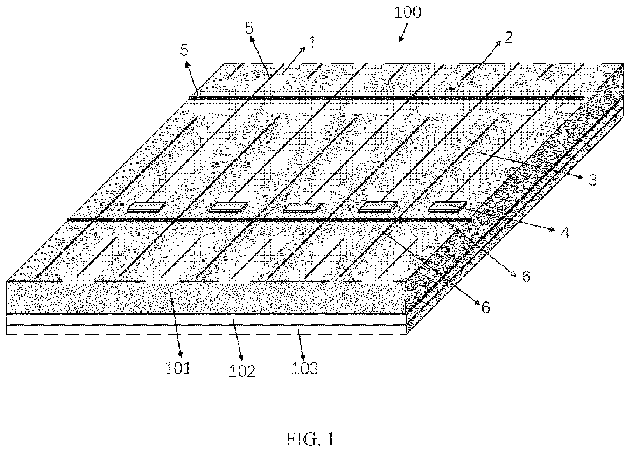

FIG. 1 to FIG. 5 illustrates a solar cell 100 of the present disclosure. The solar cell 100 includes a silicon substrate 101. The silicon substrate 101 has a front surface and a back surface. The front surface of the silicon substrate refers to the main light-receiving surface of the silicon substrate 101, while the back surface of the silicon substrate refers to the secondary light-receiving surface of the silicon substrate 101. The silicon substrate 101 includes a P-type region 1, an N-type region 2 located on the back surface of the silicon substrate 101, and an isolation region 3 located between the P-type region 1 and the N-type region 2 The solar cell 100 further includes an electrical connector 4 configured to connect a part of the P-type region 1 and a part of the N-type region 2, a first electrode 5 disposed in the P-type region 1, and a second electrode 6 disposed in the N-type region 2.

The silicon substrate 101 is an N-type silicon wafer. The P-type region 1 is a patterned region formed by performing boron diffusion on the back surface of the silicon substrate 101. The N-type region 2 is also patterned and includes a tunneling layer and an N-type polysilicon layer. The second electrode 6 is in contact with the N-type polysilicon layer.

The P-type region 1 includes a first main grid region 11 extending in a second direction and a plurality of first auxiliary grid regions 12 extending in a first direction. The plurality of first auxiliary grid regions 12 are arranged in the second direction. The first auxiliary grid region 12 is connected to the first main grid region 11.

Specifically, the first auxiliary grid region 12 crosses over the first main grid region 11 in the first direction. That is, the first auxiliary grid region 12 extends from the first main grid region 11 towards two sides in the first direction. In an optional embodiment, the first auxiliary grid region 12 is perpendicular to the first main grid region 11.

The N-type region 2 includes a second main grid region 21 extending in the second direction and a plurality of second auxiliary grid regions 22 extending in the first direction. The plurality of second auxiliary grid regions 22 are arranged in the second direction. The second auxiliary grid region 22 is connected to the second main grid region 21.

Specifically, the second auxiliary grid region 22 crosses over the second main grid region 21 in the first direction. That is, the second auxiliary grid region 22 extends from the second main grid region 21 towards two sides in the first direction. In an optional embodiment, the second auxiliary grid region 22 is perpendicular to the second main grid region 21.

The first main grid region 11 and the second main grid region 21 are alternately arranged in the first direction. The first auxiliary grid region 12 and the second auxiliary grid region 22 are alternately arranged in the second direction. In this way, the entire P-type region 1 and the entire N-type region 2 are in an interdigitated arrangement, which facilitates a carrier collection.

In the present disclosure, with the first main grid region 11 and the second main grid region 21 as a primary consideration, the P-type region 1 and the N-type region 2 are considered to be alternately arranged in the first direction as a whole.

The first auxiliary grid region 12 has a greater width than the second auxiliary grid region 22. A PN junction is formed by the P-type region 1 and the silicon substrate 101. The P-type region 1 having a relatively greater width is more favorable for generating a large number of carriers, improving a cell efficiency.

In the present disclosure, a ratio of the width of the first auxiliary grid region 12 to the width of the second auxiliary grid region 22 ranges from 2:1 to 4:1, preferably 3:1, which optimizes electrical parameters such as an open-circuit voltage, a short-circuit current, and a fill factor, thereby improving the cell efficiency.

Specifically, the width of the first auxiliary grid region ranges from 540 nm to 660 nm, and the width of the second auxiliary grid region ranges from 180 nm to 220 nm. In an embodiment, the width of the first auxiliary grid region is 600 nm, and the width of the second auxiliary grid region is 200 nm.

The isolation region 3 is located between the P-type region 1 and the N-type region 2 to separate the P-type region 1 from the N-type region 2, preventing the P-type region 1 and the N-type region 2 from being connected to each other. In an optional embodiment, a width of the isolation region 3 ranges from 50 µm to 100 µm. An excessively small width may make a fabrication process challenging, while an excessively great width wastes an effective area.

The present disclosure overcomes the limitation of complete isolation between the P-type region 1 and the N-type region 2 in a conventional back contact (BC) cell by providing the electrical connector 4 to connect the part of the P-type region 1 and the part of the N-type region 2. When the cell is partially obscured by shadow, the electrical connector 4 bypasses to connect the P-type region 1 and the N-type region 2, reducing a power loss of the cell.

From an electrical perspective, a resistance of the electrical connector 4 is smaller than a resistance of the isolation region 3; and the resistance of the electrical connector 4 is equal to or greater than a resistance of the P-type region 1, or the resistance of the electrical connector 4 is equal to or greater than a resistance of the N-type region 2. Under normal conditions without shadow obscuration, holes and electrons are collected by the first electrode located at the P-type region 1 and the second electrode located at the N-type region 2, respectively, without bypassing through the electrical connector 4. However, when the shadow obscuration occurs, the resistance of the P-type region 1 and the resistance of the N-type region 2 increase, and the P-type region 1 and the N-type region 2 are connected through the electrical connector 4.

In an embodiment, the electrical connector 4 is made of the same material as the N-type region 2, allowing the electrical connector 4 and the N-type region 2 to be fabricated together with a simple process. In an optional embodiment, the electrical connector 4 is formed by extending from the N-type region 2 towards the isolation region 3, that is, the electrical connector 4 is a part of the N-type region 2 extending to the P-type region 1.

In another embodiment, the electrical connector 4 is made of the same material as the P-type region 1, allowing the electrical connector 4 and the P-type region 1 to be fabricated together with a simple process. In an optional embodiment, the electrical connector 4 extends from the P-type region 1 towards the isolation region 3, that is, the electrical connector 4 is a part of the P-type region 1 extending to the N-type region 2.

In the present disclosure, the electrical connector 4 is located in the isolation region 3 but does not cover the entire isolation region 3. Specifically, the electrical connectors 4 are only present in some of the isolation regions 3 or in some regions of any isolation region 3. Therefore, instead of being fully connected as a single conductive body, the P-type region 1 and the N-type region 2 on the back surface are locally electrically connected through the electrical connector 4. The electrical connector 4 serves as an electrical connection point or a leakage point for the P-type region 1 and the N-type region 2. The electrical connector 4 can be regarded as a bypass diode. In this way, when the cell is partially obscured by shadow, the power loss of the cell is reduced. Under conditions without shadow obscuration, the leakage is so minimal that a normal current collection is not affected.

**In** the present disclosure, a proportion of isolation regions 3 containing the electrical connectors 4 accounts for 1% to 50% of all the isolation regions 3. That is, some isolation regions 3 do not contain the electrical connector 4 to prevent a severe leakage between the N-type region 2 and the P-type region 1, which may lower the cell efficiency.

**In** an optional embodiment, at least one isolation region 3 without the electrical connector 4 exists between two isolation regions 3 containing the electrical connectors 4, which prevents the P-type region 1 from being connected to the surrounding N-type region 2 as a whole and also prevents the N-type region 2 from being connected to the surrounding P-type region 1 as a whole.

**In** an optional embodiment, a plurality of P-type regions 1 and a plurality of N-type regions 2 are alternately arranged in the first direction. Each N-type region 2 is electrically connected through the electrical connector 4 only to a corresponding P-type region 1 at one side of the N-type region 2 in the first direction, and is not electrically connected to the P-type region 1 at the other side. Similarly, each P-type region 1 is electrically connected through the electrical connector 4 only to a corresponding N-type region 2 at one side of the P-type region 1 in the first direction. In this way, only the P-type region 1 and the N-type region 2 that are adjacent to each other are electrically connected, rather than all the P-type regions 1 and all the N-type regions 2 on the back surface being electrically connected as an entirety.

**In** an optional embodiment, a plurality of electrical connectors 4 may be provided in each isolation region 3. In an optional embodiment, the plurality of electrical connectors 4 are arranged at intervals in the second direction within the isolation region 3. Such a design reduces an area of each electrical connector 4, lowering a leakage rate. In addition, a plurality of small bypass paths can be formed based on the distribution of multiple points of the electrical connectors 4, thereby quickly establishing bypass when any region is obscured by shadow.

Specifically, the electrical connector 4 is located in the isolation region 3 around the first auxiliary grid region 12 or in the isolation region 3 around the second auxiliary grid region 22. In an optional embodiment, the electrical connector 4 is located at an end of the P-type region 1 or an end of the N-type region 2, and in this case, a cycle time (CT) of a laser etching is optimal.

Multiple first auxiliary grid regions 12 connected to the first main grid region 11 are connected to the same N-type region 2 through the electrical connector 4. Two adjacent first auxiliary grid regions 12 are connected to different parts of the second main grid region 21 through the electrical connectors 4, or two adjacent first auxiliary grid regions 12 are connected to different second auxiliary grid regions 22 through the electrical connectors 4.

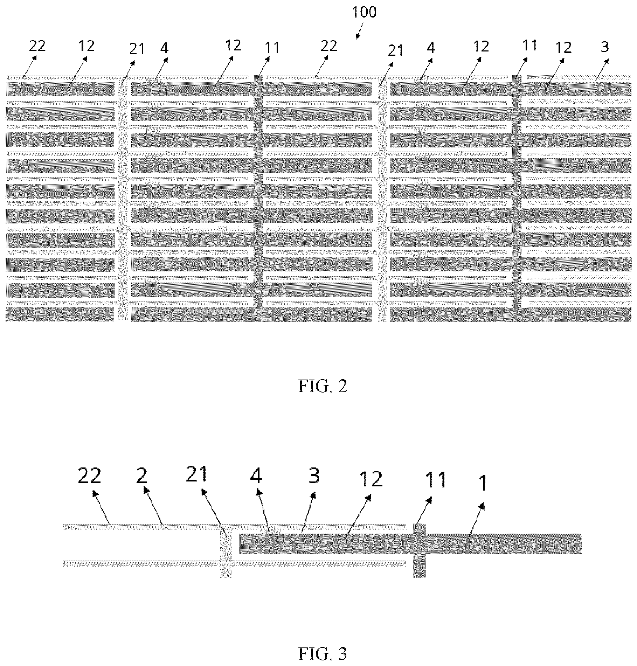

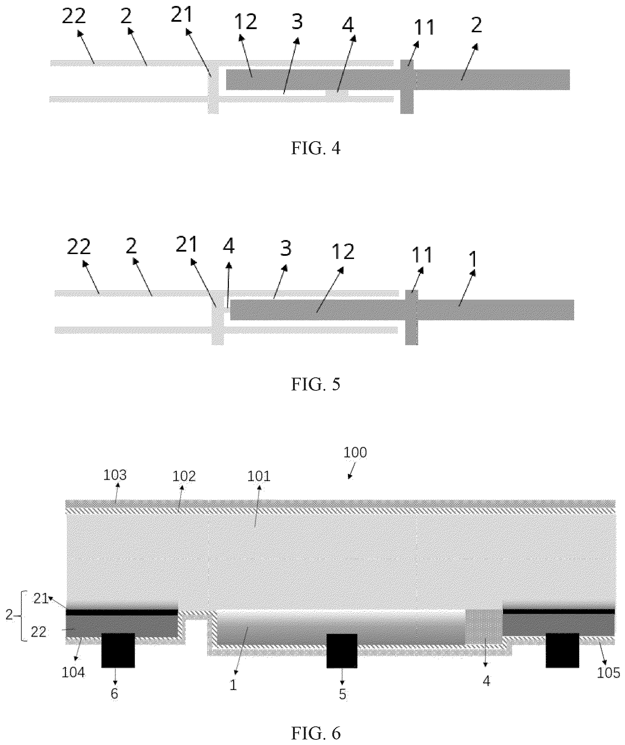

In an optional embodiment, as illustrated in FIG. 3 and FIG. 4, the electrical connector 4 is configured to connect the first auxiliary grid region 12 and the second auxiliary grid region 22. Since a current in the auxiliary grid region is smaller than that in the main grid region, a chance of leakage is low under conditions without obscuration.

In an optional embodiment, the electrical connector 4 is configured to connect the first main grid region 11 and the second auxiliary grid region 22, or as illustrated in FIG. 5, the electrical connector 4 is configured to connect the second main grid region 21 and the first auxiliary grid region 12, thereby quickly establishing when shadow obscuration occurs to avoid hot spots.

Additionally, in the entire cell, a total area of all the electrical connectors 4 accounts for 0.1% to 1% of a total area of all the isolation regions 3. Such a design ensures that the cell can be bypassed through the electrical connectors 4 when shadow obscuration occurs, and avoids a serious leakage under normal conditions.

In an optional embodiment, in each isolation region 3, an area percentage of the electrical connector 4 ranges from 0.1% to 2%.

The first electrode 5 in contact with the P-type region 1 includes a first main grid and a first auxiliary grid. The first main grid is located in the first main grid region and has a smaller width than the first main grid region. The first auxiliary grid is located in the first auxiliary grid region and has a smaller width than the first auxiliary grid region. In the present disclosure, the first main grid is a non-mandatory gate line, and the width of the first auxiliary grid ranges from 30 µm to 40 µm.

The second electrode 6 in contact with the N-type region 2 includes a second main grid and a second auxiliary grid. The second main grid is located in the second main grid region and has a smaller width than the second main grid region. The second auxiliary grid is located in the second auxiliary grid region and has a smaller width than the second auxiliary grid region. In the present disclosure, the second main grid is a non-mandatory gate line, and the width of the second auxiliary grid ranges from 30 µm to 40 µm.

In an optional embodiment, the solar cell 100 further includes a back surface passivation layer 104 and a back surface anti-reflection layer 105, which are located on a back surface of the P-type region 1 and a back surface of the N-type region 2, respectively. The first electrode 5 is in contact with the boron diffusion layer of the P-type region 1 by penetrating the back surface anti-reflection layer 105 and the back surface passivation layer 104. The second electrode 6 is in contact with an N-type crystalline silicon layer of the N-type region 2 by penetrating the back surface anti-reflection layer 105 and the back surface passivation layer 104.

It should be noted that, for clearly illustrating the positional relationships of the P-type region 1, the N-type region 2, the isolation region 3, and the electrical connector 4, the back surface passivation layer 104 and the back surface anti-reflection layer 105 are omitted in FIG. 1.

Additionally, the solar cell 100 further includes a front surface passivation layer 102 located on a front surface of the silicon substrate 101. The front surface passivation layer 102 configured to passivate the front surface and reduce an interface recombination. The front surface passivation layer 102 is an aluminum oxide layer having a thickness ranging from 3 nm to 6 nm, preferably 3 nm to 5 nm.

The solar cell 100 further includes a front surface anti-reflection layer 103 located on a front surface of the front surface passivation layer 102. The front surface anti-reflection layer 103 is configured to reduce reflectivity and enhance light absorption. The front surface anti-reflection layer 103 is selected from a laminated film made of one or more of silicon nitride, silicon oxynitride, or silicon oxide and has a thickness ranging from 60 nm to 130 nm, preferably 70 nm to 80 nm.

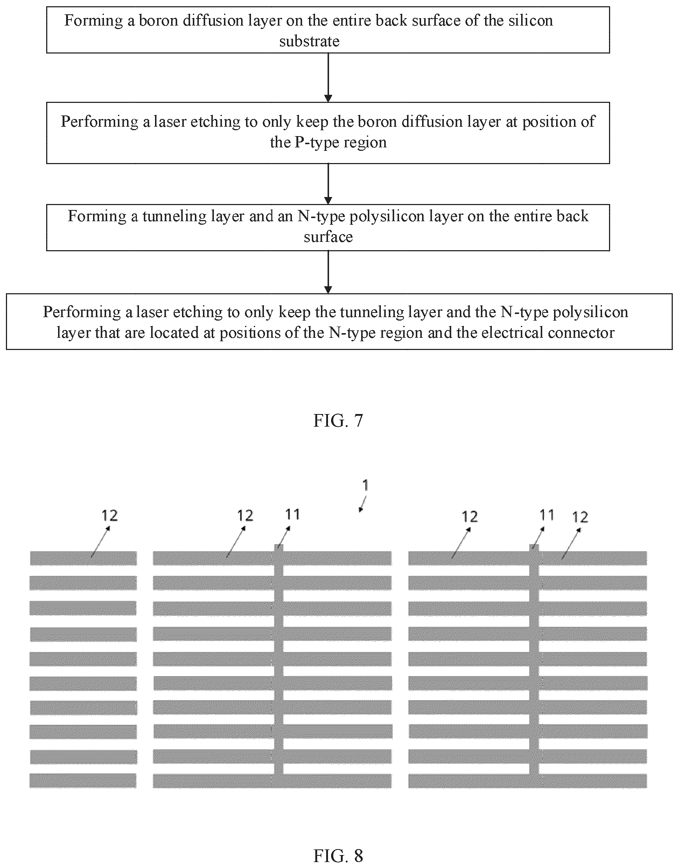

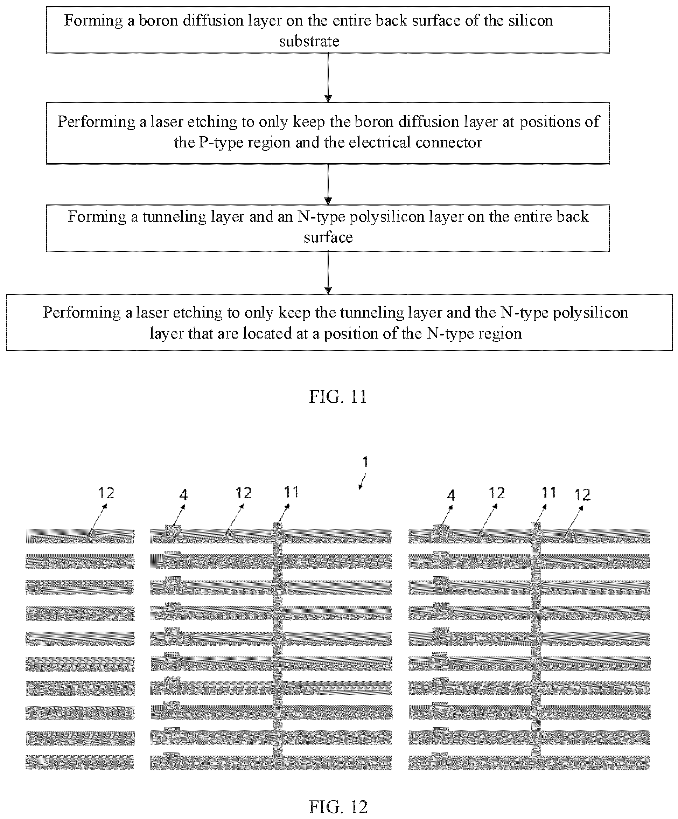

As illustrated in FIG. 7 to FIG. 12, the present disclosure further provides a method for preparing a solar cell. The method includes: forming a patterned P-type region 1 on a back surface of a silicon substrate 101; forming a patterned N-type region 2 on the back surface of the silicon substrate 101, an isolation region 3 existing between the N-type region 2 and the P-type region 1; and forming an electrical connector 4 on the back surface of the silicon substrate 101 to electrically connect a part of the P-type region 1 and a part of the N-type region 2.

Structures of and positional relationships of the P-type region 1, the N-type region 2, the isolation region 3, and the electrical connector 4 are identical to those as described for the above solar cell 100, which are not described in detail herein. The preparation processes are described in detail below.

The electrical connector 4 is formed at a part of the isolation region 3, without occupying an additional effective area of the back surface or affecting a structural arrangement of the back surface.

In a first embodiment, referring to FIG. 7 to FIG. 9, the electrical connector 4 is made of the same material as the N-type region 2 and is formed synchronously with the N-type region 2.

The method for preparing the solar cell includes: forming the patterned P-type region 1, and synchronously forming the patterned N-type region 2 and the electrical connector 4.

Specifically, the patterned P-type region 1 is formed by the following operations.

The boron diffusion layer is formed by performing boron diffusion on the entire back surface of the silicon substrate 101. The boron diffusion layer has a doping concentration ranging from 5E18 cm⁻³ to 5E19 cm⁻³, a sheet resistance ranging from 250 ohm/sq to 350 ohm/sq, and a junction depth ranging from 0.5 µm to 0.1 µm.

The boron diffusion layer located outside the P-type region 1 is removed by performing film-removing processing, merely keeping the boron diffusion layer at a position of the P-type region 1 to form the patterned P-type region 1. Preferably, the film-removing processing is a laser etching using a laser, and the laser is a green laser with a power ranging from 50 W to 120 W or an ultraviolet laser with a power ranging from 30 W to 60 W. Preferably, ultraviolet picosecond laser light or green picosecond laser light is adopted due to their low damage and costs; or femtosecond laser light may also be adopted.

The patterned N-type region 2 is formed by the following operations.

A tunneling layer and an N-type amorphous silicon layer are formed on the entire back surface. Preferably, a phosphorus-doped amorphous silicon layer is grown using PECVD in-situ doping.

The N-type amorphous silicon layer is converted into the N-type polysilicon layer by performing annealing.

A film-removing processing is performed to only keep the tunneling layer and the N-type polysilicon layer that are located at positions of the N-type region 2 and the electrical connector 4. The N-type region 2 and the electrical connector 4 are synchronously formed, and the electrical connector 4 is made of the same material as the N-type region 2. The film-removing processing process here is consistent with that used for forming the P-type region 1, and thus details thereof will be omitted herein.

Specifically, the tunneling layer is selected from a silicon oxide layer (SiOx) or a silicon carbide layer (SiC) and has a thickness ranging from 1 nm to 3 nm, preferably 1 nm to 2.5 nm, and more preferably 1 nm to 2 nm, or 1.5 nm to 2 nm, or 1.5 nm to 2.5 nm. The thickness of the tunneling layer 31 is optimized based on denseness of the tunneling layer 31. When the tunneling layer 31 is made of SiOx, the thickness of the tunneling layer 31 ranges from 1.4 nm to 2.3 nm. When the tunneling layer 31 is made of SiC, the layer is denser and thus has a thickness ranging from 1 nm to 1.8 nm.

The N-type polysilicon layer is a phosphorus-doped polysilicon layer, a carbon-doped polysilicon layer, or a nitrogen-doped polysilicon layer. As an example, the phosphorus-doped polysilicon layer is described below. An annealing temperature ranges from 850°C to 980°C; a doping concentration of the N-type polysilicon layer ranges from 3E20 cm⁻³ to 5E20 cm⁻³, and the thickness of the N-type polysilicon layer ranges from 80 nm to 130 nm, which can be set to 90 nm, 95 nm, 100 nm, 105 nm, 110 nm, 115 nm, or 120 nm.

In an optional embodiment, the method for preparing the solar cell further includes the following operations.

The front surface passivation layer 102 and the back surface passivation layer 104 are formed on the entire front surface and the entire back surface, respectively. According to the present disclosure, an ALD process is adopted to deposit an aluminum oxide passivation layer on each of the two surfaces, providing a satisfactory passivation effect for both the P-type region 1 and the N-type region 2. A thickness of the aluminum oxide passivation layer ranges from 3 nm to 6 nm, preferably 3 nm to 5 nm.

The front surface anti-reflection layer 103 and the back surface anti-reflection layer 105 are formed on the entire front surface and the entire back surface, respectively, to reduce reflectivity of the two surfaces. According to the present disclosure, a PECVD process is adopted to deposit a laminated film composed of one or more of silicon nitride, silicon oxynitride, or silicon oxide at each of the two surfaces. The front surface anti-reflection layer 103 and the back surface anti-reflection layer 105 have each a thickness ranging from 60 nm to 130 nm, preferably 70 nm to 80 nm.

The first electrode 5 and the second electrode 6 are formed at the P-type region 1 and the N-type region 2, respectively. Specifically, the first electrode 5 and the second electrode 6 can be formed by screen printing or sintering. The first electrode 5 is in contact with the P-type region 1 by penetrating the back surface anti-reflection layer 105 and the back surface passivation layer 104. The second electrode 6 is in contact with the N-type polysilicon layer by penetrating the back surface anti-reflection layer 105 and the back surface passivation layer 104.

Specifically, the first electrode 5 and the second electrode 6 are formed by the following process: screen printing the second auxiliary grid → drying →screen printing the first auxiliary grid → drying → screen printing the first main grid and the second main grid → sintering.

In an optional embodiment, the method for preparing the solar cell further includes a post-processing, testing, and sorting.

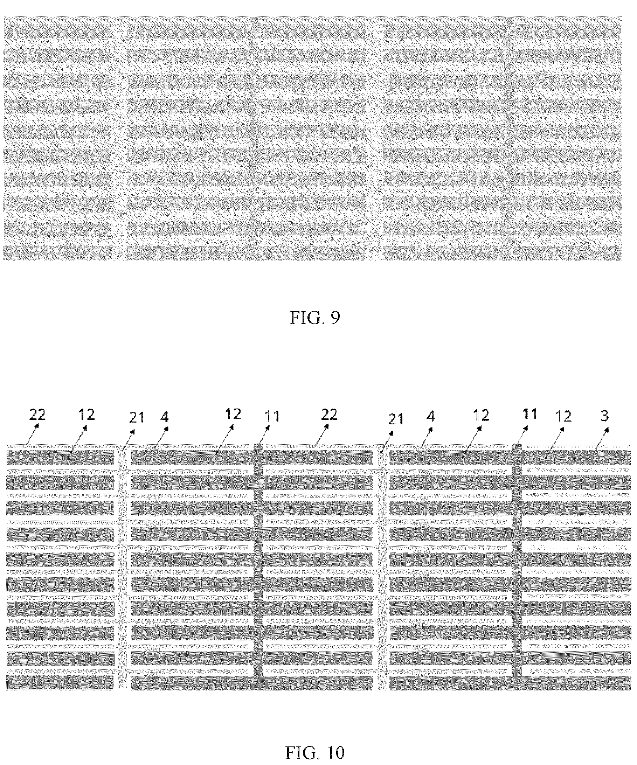

In a second embodiment, referring to FIG. 10 to FIG. 12, the electrical connector 4 is made of the same material as the P-type region 1 and is formed synchronously with the P-type region 1.

The method for preparing the solar cell includes: synchronously forming the patterned P-type region 1 and the electrical connector 4, and forming the patterned N-type region 2. The second embodiment differs from the first embodiment in the operations as described below.

The patterned P-type region 1 is formed by the following operations: forming the boron diffusion layer by performing boron diffusion on the entire back surface of the silicon substrate 101; and performing film-removing processing to only keep the boron diffusion layer at positions of the P-type region 1 and the electrical connector 4. The patterned P-type region 1 and the electrical connector 4 are synchronously formed, and the electrical connector 4 is made of the same material as the P-type region 1.

The patterned N-type region 2 is formed by the following operations: forming the tunneling layer and the N-type amorphous silicon on the entire back surface; converting the N-type amorphous silicon layer into the N-type polysilicon layer by performing annealing; and performing film-removing processing to only keep the tunneling layer and the N-type polysilicon layer that are located at the position of the N-type region 2.

Other operations are the same as those in the first embodiment, which are not described in detail herein.

In summary, in the solar cell 100 of the present disclosure, by providing the electrical connector 4, a part of the P-type region 1 and a part of the N-type region 2 are electrically connected to each other. In this way, the electrical connector 4 serves as a bypass path when the cell is partially obscured by shadow, thereby reducing a power loss of the cell. About 70% of original power can be retained.

It should be understood that, although the specification is described in accordance with the embodiments, not each embodiment contains only one independent technical solution. The specification is described in this manner only for the sake of clarity. Those skilled in the art should consider the specification as a whole. Also, the technical solutions in different embodiments can be combined appropriately to form other embodiments that can be understood by those skilled in the art.

The detailed descriptions set forth above are merely specific explanations for feasible embodiments of the present disclosure and are not intended to limit the scope of protection of the present disclosure. Any equivalent implementations or modifications made without departing from the spirit of the present disclosure shall fall within the scope of protection of the present disclosure.

## Claims

1. A solar cell, comprising:
a silicon substrate having a front surface and a back surface, wherein the silicon substrate comprises a P-type region located on the back surface, an N-type region located on the back surface; and an isolation region located between the P-type region and the N-type region;
a first electrode disposed in the P-type region;
a second electrode disposed in the N-type region; and
an electrical connector disposed in the isolation region and configured to electrically connect a part of the P-type region and a part of the N-type region.

2. The solar cell according to claim 1, wherein:
a resistance of the electrical connector is smaller than a resistance of the isolation region; and
the resistance of the electrical connector is equal to or greater than a resistance of the P-type region, or the resistance of the electrical connector is equal to or greater than a resistance of the N-type region.

3. The solar cell according to claim 1, wherein:
the electrical connector is made of the same material as the N-type region, and the electrical connector extends from the N-type region towards the isolation region; or
the electrical connector is made of the same material as the P-type region, and the electrical connector extends from the P-type region towards the isolation region.

4. The solar cell according to claim 1, wherein:
the silicon substrate comprises a plurality of P-type regions and a plurality of N-type regions, the plurality of P-type regions and the plurality of N-type regions being altemately arranged in a first direction, wherein:
each of the plurality of N-type regions is electrically connected to a corresponding one of the plurality of P-type regions through the electrical connector at only one side of the N-type region in the first direction; or
each of the plurality of P-type regions is electrically connected to a corresponding one of the plurality of N-type regions through the electrical connector at only one side of the P-type region in the first direction.

5. The solar cell according to claim 4, wherein:
each of the plurality of P-type regions comprises a first main grid region extending in a second direction and a plurality of first auxiliary grid regions extending in the first direction, the plurality of first auxiliary grid regions being arranged in the second direction, and the plurality of first auxiliary grid regions being connected to the first main grid region;
each of the plurality of N-type regions comprises a second main grid region extending in the second direction and a plurality of second auxiliary grid regions extending in the first direction, the plurality of second auxiliary grid regions being arranged in the second direction, the plurality of second auxiliary grid regions being connected to the second main grid region;
the first main grid regions of the plurality of P-type regions and the second main grid regions of the plurality of N-type regions are alternately arranged in the first direction, and the plurality of first auxiliary grid regions of each of the plurality of P-type regions and the plurality of second auxiliary grid regions of a corresponding one of the plurality of N-type regions are alternately arranged in the second direction.

6. The solar cell according to claim 5, wherein:
the electrical connector is located in the isolation region around the first auxiliary grid region; or
the electrical connector is located in the isolation region around the second auxiliary grid region.

7. The solar cell according to claim 6, wherein:
each of the plurality of second auxiliary grid regions is connected to the first main grid region through the electrical connectors; or
each of the plurality of first auxiliary grid regions is connected to the second main grid region at different part through the electrical connector; or
each of the plurality of first auxiliary grid regions is connected to one of the plurality of second auxiliary grid regions adjacent to the first auxiliary grid region through the electrical connector.

8. The solar cell according to claim 4, wherein the first direction is perpendicular to the second direction.

9. The solar cell according to claim 4, wherein, for the isolation region between adjacent P-type region and N-type region:
a ratio of an area of the electrical connectors to an area of the isolation region ranges from 0.1% to 2%.

10. A method for preparing the solar cell according to any one of claims 1 to 9, the method comprising:
forming a patterned P-type region on a back surface of a silicon substrate;
forming a patterned N-type region on the back surface of the silicon substrate, wherein an isolation region is formed between the N-type region and the P-type region;
forming an electrical connector in the isolation region on the back surface of the silicon substrate; and
forming a first electrode and a second electrode at the P-type region and the N-type region, respectively.

11. The method for preparing the solar cell according to claim 10, comprising, in sequence:
forming a boron diffusion layer on the entire back surface of the silicon substrate, and performing a laser etching to only keep the boron diffusion layer at a position of the P-type region; and
forming a tunneling layer and an N-type polysilicon layer on the entire back surface, and performing a laser etching to only keep the tunneling layer and the N-type polysilicon layer that are located at positions of the N-type region and the electrical connector.

12. The method for preparing the solar cell according to claim 10, comprising, in sequence:
forming a boron diffusion layer on the entire back surface of the silicon substrate, and performing a laser etching to only keep the boron diffusion layer at positions of the P-type region and the electrical connector; and
forming a tunneling layer and an N-type polysilicon layer on the entire back surface, and performing a laser etching to only keep the tunneling layer and the N-type polysilicon layer that are located at a position of the N-type region.

13. The method for preparing the solar cell according to any one of claims 10 to 12, wherein:
the P-type region is a boron diffusion region having a doping concentration ranging from 5E18 cm⁻³ to 5E19 cm⁻³ or a sheet resistance ranging from 250 ohm/sq to 350 ohm/sq and having a junction depth ranging from 0.5 µm to 0.1 µm; and
the N-type region is phosphorus doped, carbon doped, or nitrogen doped, the N-type region having a doping concentration ranging from 3E20cm⁻³ to 5E20cm⁻³.

14. The method for preparing the solar cell according to claim 11 or 12, wherein said forming the tunneling layer and the N-type polysilicon layer on the entire back surface comprises:
growing the tunneling layer and an N-type amorphous silicon layer through PECVD by in-situ doping; and
converting, by annealing at 850 °C to 980 °C, the N-type amorphous silicon layer into the N-type polysilicon layer.

15. The method for preparing the solar cell according to any one of claims 10 to 12, the method further comprising, subsequent to said forming the electrical connector, and prior to said forming the first electrode and the second electrode at the P-type region and the N-type region, respectively:
forming a passivation layer on the entire back surface and an entire front surface of the silicon substrate; and
forming an anti-reflection layer on the entire back surface and the entire front surface of the silicon substrate,
wherein the first electrode is in contact with the P-type region by penetrating the anti-reflection layer and the passivation layer that are located on the back surface of the silicon substrate, and wherein the second electrode is in contact with the N-type polysilicon layer by penetrating the anti-reflection layer and the passivation layer that are located on the back surface of the silicon substrate.
